# EUROPEAN PATENT APPLICATION

(11) **EP 0 828 298 A2**
(43) Date of publication of application: **11.03.1998**
(21) Application number: 97110313.0
(22) Date of filing: 24.06.1997
(51) Int. Cl.: H01L 31/0203, H01L 31/0232, H01L 31/0216, H01L 27/146

(54) **Imaging apparatus and process for producing the same**

(30) Priority: 06.09.1996 JP 236303/96
(71) Applicant: MATSUSHITA ELECTRONICS CORPORATION, Takatsuki-shi, Osaka 569-11 (JP)
(72) Inventor: Sano, Yoshikazu, Osaska-shi, Osaka 543 (JP); Terakawa, Sumio, Ibaraki-shi, Osaka 567 (JP); Asaumi, Masaji, Kyoto-shi, Kyoto 615 (JP); Chatani, Yoshikazu, Kyoto-shi, Kyoto 607 (JP); Tanaka, Hiromichi, Hirakata-shi, Osaka 573 (JP)
(74) Representative: Grünecker, Kinkeldey, Stockmair & Schwanhäusser Anwaltssozietät

(57) **Abstract**

An imaging apparatus in that a solid state imaging device chip and a relevant peripheral circuit element chips are mounted in the form of a bare chip within the same planar package. Thus, the imaging apparatus is made compact, lightweight and slim and besides the leading of wiring is decreased with the effect of improving electrical characteristics. Further, the use of a flat electroconductive substrate with an insulating film formed on its surface as the substrate mounted with the solid state imaging device chip and the relevant peripheral circuit element chips makes it possible to mount high-density element chips because improvement in wiring density and thermal radiation is achievable.

## Description

### BACKGROUND OF THE INVENTION

The present invention relates to an imaging apparatus comprising a solid state imaging device, a driving circuit for driving the solid state imaging device, a signal processing circuit for processing images from the solid state imaging device, a control circuit for controlling these component parts and the like, and to a process for producing the same.

In the field of consumer video cameras (camcorders) nowadays, there is a growing demand for high image quality in order to not only materialize faithful color reproduction and expressiveness of minute details but also make such video cameras compact, slim and lightweight for the convenience of carrying them. In compliance with the demand, there has been developed the technology of making smaller and slimmer imaging apparatus inclusive of solid state imaging devices and peripheral circuits of them.

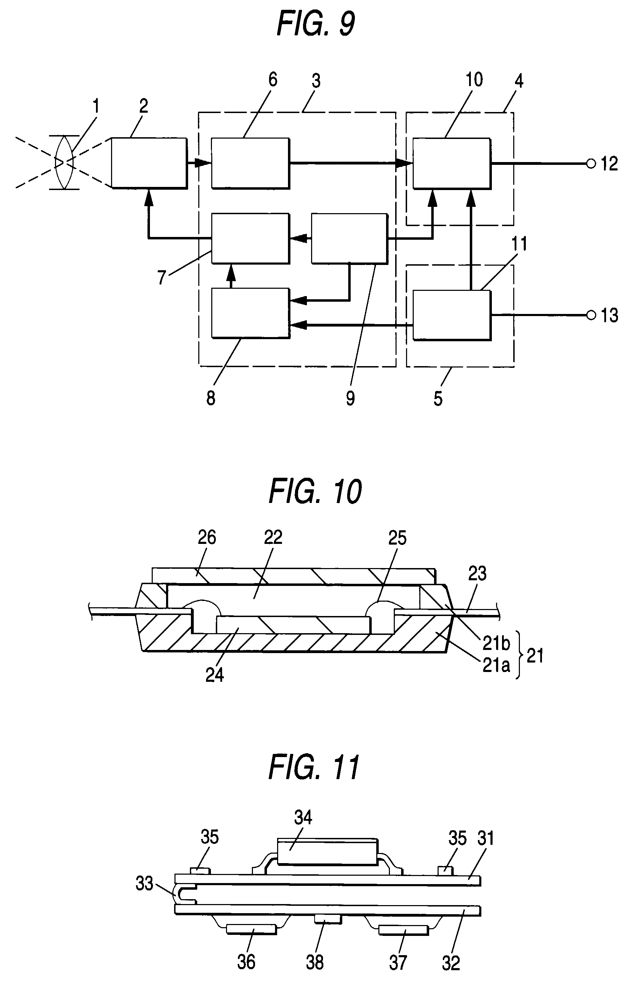

Fig. 9 is a block diagram of a circuit in a typical imaging apparatus. In Fig. 9, reference numeral 1 denotes an optical lens; 2, a solid state imaging device; 3, a driving unit of the solid state imaging device 2; 4, a signal processing unit for processing a signal that is output form the solid state imaging device 2; and 5, a control unit of the imaging apparatus. The driving unit 3 is mainly formed with a correlated double sampling circuit (CDS circuit) 6, a vertical driver circuit 7, a control gate circuit (CG circuit) 8 with respect to the vertical diver circuit 7, a scanning-signal generating circuit (SSG circuit) 9 for supplying a vertical scanning signal and so forth. The signal processing unit 4 is mainly formed of a signal processing circuit 10 for converting a signal from the CDS circuit 6 to a video signal, which is output from an analog signal output terminal 12. Further, the control unit 5 is mainly formed of a microcomputer 11 and exchanges signals with the outside via an I/O terminal 13.

With the arrangement above, a signal from the I/O terminal 13 causes a control signal to be fed from the control unit 5 into the CG circuit 8 and the signal processing circuit 10. Upon receipt of the control signal from the control unit 5, the CG circuit 8 drives the vertical driver circuit 7, which outputs a vertical driver signal to make the solid state imaging device 2 operate. The signal that is output from the solid state imaging device 2 is first processed by the CDS circuit 6 before being sent out to the signal processing circuit 10. A video signal from the signal processing circuit 10 is output via the analog signal output terminal 12.

Fig. 10 is a sectional view of the principal part of a conventional solid state imaging device. In Fig. 10, reference numeral 21 denotes a ceramic package; 21a, a container; 21b, a frame body, the container 21a and the frame body 21b constituting the ceramic package 21; 22, a recessed portion; 23, a lead; 24, a solid state imaging chip; 25, thin metal wires; and 26, a glass plate. Although the example of Fig. 10 shows the lead 23 held between the container 21a and the frame body 21b of the ceramic package 21, metallized wiring, instead of the lead 23, may be formed on the surface of the container 21a and the lead 23 is connected to the metallized wiring on the outside.

The conventional solid state imaging device is formed through the steps of firmly bonding the solid state imaging device chip 24 onto the recessed portion 22 of the ceramic package 21 with, for example, an electroconductive adhesive, connecting the electrode (not shown) of the solid state imaging device chip 24 and the lead 23 by means of the thin metal wire 25, and covering the recessed portion 22 with the glass plate 26 to seal up the hollow thus formed thereby.

Fig. 11 shows an example of a conventional imaging apparatus. In Fig. 11, reference numeral 31 denotes a first printing wiring board; 32, a second printed wiring board; 33, a flexible cable for connecting the circuit formed on the first printed wiring board 31 and what is formed on the second printed wiring board; 34, the packaged solid state imaging device shown in Fig. 10; 35, circuit component parts such as a resistor and a capacitor; 36, 37, peripheral circuit elements constituting the driving circuit portion and the signal processing circuit portion of the solid state imaging device; and 38, a circuit component part such as a resistor and a capacitor.

As shown in Fig. 11, the conventional imaging apparatus employs two sheets of printed wiring boards 31, 32 and the solid state imaging device 34 as well as the circuit parts 35 mounted on the ceramic package is packaged, whereas the peripheral circuit elements 36, 37 are packaged on the second printed wiring board 32. These printed wiring boards were about 4cm square and height resulting from stacking the two printed wiring boards was about 1cm. The illustration of an optical lens, the mounting of which is essential to such an imaging apparatus though, has been omitted in Fig. 11.

An imaging apparatus of the sort described above is increasingly used for various purposes as an imaging unit in video cameras and electronic still cameras but in any field of use it has become essential to not only improve the functional performance of the apparatus but also make it smaller, lighter and thinner. Although the structure shown in Fig. 11 has been designed to be compact though not quite satisfactory by reducing the solid state imaging device chip and several peripheral circuit element chips to modules, the use of packaged semiconductor devices and the use of soldering for connecting parts to the printed wiring board have set limits to making the imaging apparatus smaller and thinner. Moreover, the expanded leading of the wire on the printed wiring board tends to increase the wiring capacity and the problem is that charging and discharging with respect to the wiring capacity causes unnecessary radiation. Further, a signal delay occurs as the leading of the wire expands and this also sets limits to raising the speed of signal transmission.

In the conventional imaging apparatus, the arrangement of the solid state imaging device chip and the peripheral circuit element chips remains unregulated, and common practice has been to place the solid state imaging device chip on the upper side when it is set upright for use. Therefore, the heating value of the imaging apparatus has become impossible to disregard as the density of such a solid state imaging device chip is increased. In other words, the heat generated by the solid state imaging device chip also causes the atmosphere within the package to be heated and the circulation of heat by convection results in a temperature difference in the vertical direction of the package. Since the dark current of the solid state imaging device chip is sensitive to temperature, the variation of which is said to be about twofold/(8-10°C). As the dark current increases, pictures becomes rough when dark scenes are photographed and consequently image quality is deteriorated.

### SUMMARY OF THE INVENTION

An object of the present invention intended to solve the foregoing problems is to provide an imaging apparatus designed to reduce semiconductor devices to modules by rendering compact, lightweight and slim a solid state imaging device, a driving unit, a signal processing unit and a control unit constituting a semiconductor device, and to suppress the deterioration of image quality.

In order to accomplish the object above by means of an imaging apparatus according to the present invention wherein a solid state imaging device chip and a relevant peripheral circuit element chips are mounted in the form of a bare chip within the same planar package. Thus, the imaging apparatus is made compact, lightweight and slim and besides the leading of wiring is decreased with the effect of improving electrical characteristics.

The use of a flat electroconductive substrate with an insulating film formed on its surface as the substrate mounted with the solid state imaging device chip and the relevant peripheral circuit element chips makes it possible to mount high-density element chips because improvement in wiring density and thermal radiation is achievable.

When a photograph is taken by setting upright the principal surface of the solid state imaging device chip as far as the arrangement of the solid state imaging device chip and the peripheral circuit element chips is concerned, at least the peripheral circuit element chip having a greater heat value is disposed on the substrate so that it is placed above the solid state imaging device chip, whereby the solid state imaging device chip is less affected by heat. Consequently, the deterioration of image quality is suppressed.

Moreover, mounting accuracy can be improved when the imaging apparatus is incorporated into a camera by conforming the center of the imaging area of the solid state imaging device chip onto the bisector of one side of the external shape of the package of the imaging apparatus or otherwise conforming the intersection point of diagonal lines of the external shape of the package to the center of the imaging area of the solid state imaging device chip.

According to the invention, an imaging apparatus is such that a substrate mounted with a solid state imaging device chip and peripheral circuit element chips thereon is contained in the depression of a container and that the container is sealed up with a cover body made of a transparent member in such a manner as to make the depression hollow. Therefore, electrical characteristics are improved because the imaging apparatus is made compact and the leading of wiring is reduced.

Furthermore, according to the invention, a light shielding film having a transparent portion corresponding to the imaging area of the solid state imaging device chip is formed on at least one of the surface and the undersurface of the cover body made of the transparent member. Therefore, in addition to reduction in size and improvement in electrical characteristics, the solid state imaging device chip is made less affected by external light.

Furthermore, according to the invention, a lens-like transparent material is disposed in an area on the surface or undersurface of the cover body corresponding to the transparent portion provided in a part of the light shielding film. Therefore, in addition to reduction in size and improvement in electrical characteristics, the quantity of light incident on the solid state imaging device chip can be increased.

Furthermore, according to the invention, the substrate mounted with the solid state imaging device chip and the peripheral circuit element chips thereon is the electroconductive substrate with an insulating film formed on the surface and further thin-film conductor wiring formed on the insulating film. Therefore, the imaging apparatus can be made smaller since fine wiring and multi-layer wiring are readily formable on the substrate. Moreover, the use of the electroconductive substrate prevents unnecessary radiation.

Furthermore, according to the invention, the substrate mounted with the solid state imaging device chip and the peripheral circuit element chips is either silicon or metal substrate with an insulating film formed thereon and besides thin-film conductor wiring is formed on the insulating film. In a case particularly where the substrate is a silicon substrate, semiconductor manufacturing technology is utilizable for forming fine wiring and multilayer wiring readily on the substrate.

Furthermore, according to the invention, the substrate mounted with the solid state imaging device chip and the peripheral circuit element chips thereon is what is formed by forming an electroconductive film on an insulating substrate and further forming an insulating film thereon and wherein thin-film conductor wiring is formed on the insulating film. Therefore, unnecessary radiation can be prevented even though an inexpensive substrate is used.

Furthermore, according to the invention, the substrate mounted with the solid state imaging device chip and the peripheral circuit element chips thereon is an insulating substrate and wherein thin-film conductor wiring is formed on the one-side principal surface of the insulating substrate, whereas an electroconductive film is formed over substantially the whole the-other-side principal surface thereof. The process of manufacture can be simplified because the electroconductive film formed on the-other-side principal surface is not a thin film but may be an electroconductive film of an application type.

Furthermore, according to the invention, the solid state imaging device chip is mounted on the substrate faceup with the peripheral circuit element chips formed on the substrate facedown. Since the solid state imaging device chip is such that the principal surface where the circuit is formed, a light shielding film is not necessarily required for the cover body made of the transparent member.

Furthermore, according to the invention, an imaging apparatus is such that peripheral circuit element chips are packaged in a predetermined area on a semiconductor substrate which incorporates a solid state imaging device chip and thin-film conductor wiring in one principal surface of the semiconductor substrate and that a container is sealed up and hollowed out by a cover body whose area corresponding to the imaging area of at least the solid state imaging device chip is transparent. Therefore, the imaging apparatus can be made smaller and slimmer.

Furthermore, according to the invention, the peripheral circuit element chips are mounted facedown. Since the solid state imaging device chip is such that the principal surface where the circuit is formed, a light shielding film is not necessarily required for the cover body made of the transparent member.

Furthermore, according to the invention, at least the surface of the peripheral circuit element chip is covered with opaque plastics. The light shielding film is not necessarily required for the cover body made of the transparent member.

Furthermore, according to the invention, an imaging apparatus is such that a substrate mounted with a solid state imaging device chip and peripheral circuit element chips thereon is contained in the depression of a container and that the container is sealed up with a cover body which is made of a opaque member and has a transparent window above the solid state imaging device chip. Although the structure of the cover body is complicated, the solid state imaging device chip can completely shielded from light.

Furthermore, according to the invention, a surface or an undersurface as the principal surface of the transparent window is equipped with a lens-like transparent material. Therefore, light incident on the solid state imaging device chip can be increased. Moreover, any external lens can be dispensed with by adopting a pin-hole lens instead of a lens-like transparent material, so that a camera system with an extra-thin type lens is provided.

Furthermore, according to the invention, an imaging apparatus is such that the solid state imaging device chip and the peripheral circuit element chips are disposed on the substrate so that when the principal surface of an imaging device is held in parallel to a perpendicular line so as to take a photograph, at least one of the peripheral circuit element chips which generates heat greater than the solid state imaging device chip is placed above the solid state imaging device chip. Therefore, the solid state imaging device chip is prevented from being heated by the circulation of heat by convection resulting from the heat generation of the peripheral circuit element chips. By suppressing a rise in the temperature of the solid state imaging device chip, an increase in dark current is also suppressed, so that when dark scenes are photographed, deterioration of image quality is reducible.

Furthermore, according to the invention, the solid state imaging device chip is placed so that the center of the imaging area of the solid state imaging device chip conforms to the bisector of one side of the external shape of the container. Therefore, the optical center is obtainable with ease when the imaging apparatus is assembled in the camera or the like.

Furthermore, according to the invention, the solid state imaging device chip is placed so that the center of the imaging area of the solid state imaging device chip conforms to the intersection point of diagonal lines of the external shape of the container. Therefore, the optical center is obtainable with higher accuracy.

Furthermore, according to the invention, a process for producing an imaging apparatus comprises the steps of forming a first insulating film, first thin-film conductor wiring on the first insulating film on an electroconductive substrate, a second insulating film covering the first thin-film conductor wiring and second thin-film conductor wiring on the second insulating film, packaging a solid state imaging device chip and peripheral circuit element chips on the substrate, connecting the electrode of each chip to either first or second thin-film conductor wiring, installing the substrate within a container, connecting either first or second thin-film conductor wiring on the substrate to the external lead of the container, and hermetically sealing up the container with a cover body having a transparent portion in a portion corresponding to the imaging area of at least the solid state imaging device chip. Thus, a high-density imaging apparatus can be packaged and tests for the operation of the imaging apparatus can be made in accordance with the condition of the substrate.

Furthermore, according to the invention, a silicon substrate is used for the electroconductive substrate and consequently the semiconductor manufacturing technology is utilizable for readily forming a high-density wiring substrate.

### BRIEF DESCRIPTION OF THE DRAWINGS

Figs. 1A to 1C are sectional views of an imaging apparatus according to first embodiment of the present invention;
Fig. 2 is a sectional view of an imaging apparatus according to second embodiment of the present invention;
Fig. 3 is a sectional view of an imaging apparatus according to third embodiment of the present invention;
Fig. 4 is a sectional view of an imaging apparatus according to fourth embodiment of the present invention;
Figs. 5A and 5B are sectional views of an imaging apparatus according to fifth embodiment of the present invention;
Fig. 6 is a sectional view explanatory of a state in which an imaging apparatus according to sixth embodiment of the present invention is installed on a circuit substrate;
Fig. 7 is a development of an imaging apparatus according to seventh embodiment of the present invention;
Figs. 8A to 8G are sectional views explanatory of steps in the process of manufacturing an imaging apparatus according to eighth embodiment of the present invention;
Fig. 9 is a block diagram of a circuit in an ordinary imaging apparatus;
Fig. 10 is a sectional view of the principal part of a conventional solid state imaging device; and
Fig. 11 is a diagram illustrating a conventional imaging apparatus.

### DETAILED DESCRIPTION OF THE PREFERRED EMBODIMENTS

Embodiments of the present invention will subsequently be described by reference to the drawings.

### First Embodiment

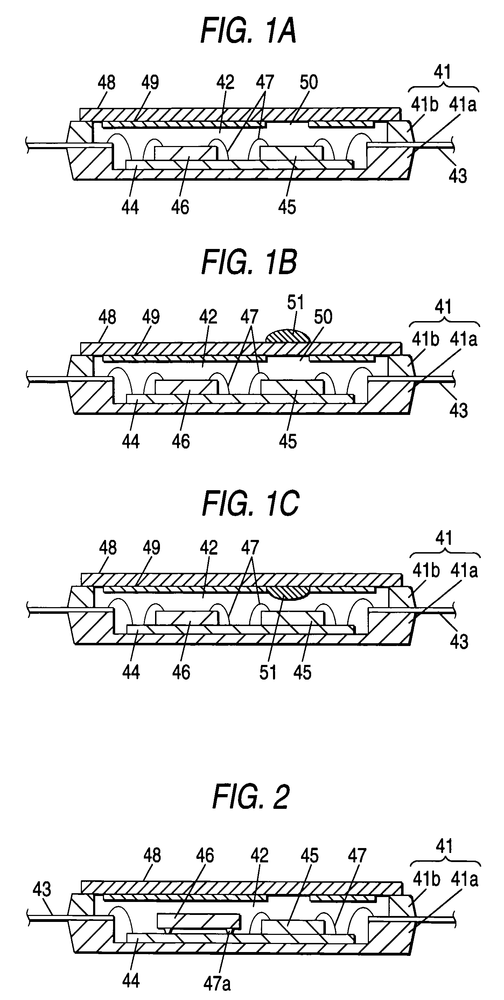

Fig. 1A is a sectional view of an imaging apparatus according to first embodiment of the present invention, wherein reference numeral 41 denotes a ceramic package; 41a, a container; 41b, a frame body 41b, the ceramic package 41 and the frame body 41b constituting the ceramic package 41; 42, a depression 42; 43, a lead; 44, a substrate; 45, a solid state imaging device chip; 46, a peripheral circuit element chip; 47, thin metal wires; 48, a glass plate; 49, a light shielding film; and 50, a transparent portion.

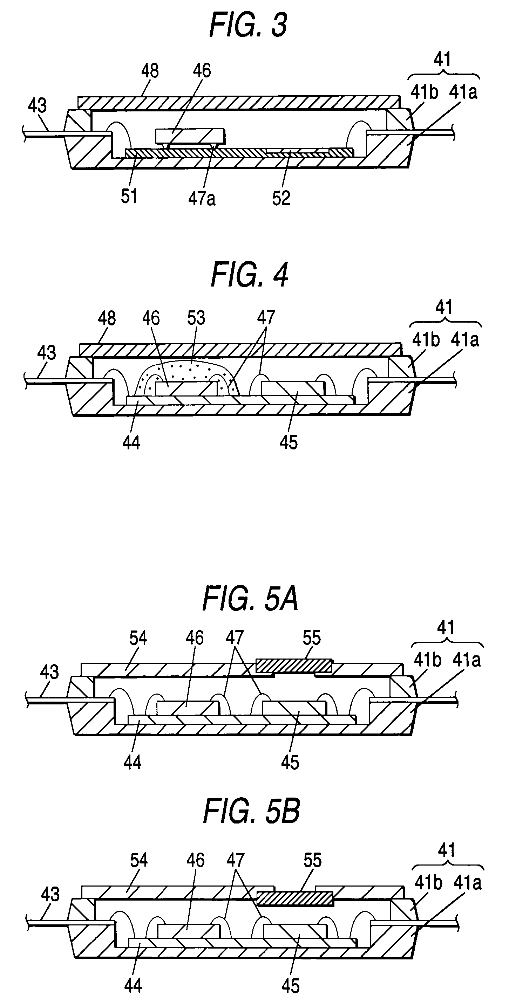

Conductor wiring (not shown) is formed on the surface of substrate 44, and the solid state imaging device chip 45 as well as the peripheral circuit element chip 46 is fixedly bonded in a predetermined position with electroconductive paste, for example. Although only one peripheral circuit element chip 46 is shown in Fig. 4A, actually bare chips of ICs constituting the driving unit of the solid state imaging device chip 45, a signal processing unit, and a control unit are mounted. The thin metal wires 47 are used for connecting between thin film conductor wiring on the peripheral circuit element chip 46 and the substrate 44 and between the thin film conductor wiring and the lead 43, respectively. If the bare chips of the peripheral circuit element chip 46 are irradiated by intense light, photoelectromotive force may generate unnecessary voltage in this circuit to cause malfunction. Therefore, it is necessary to irradiate only the solid state imaging device chip 45 with light, but shield the peripheral circuit element chip 46 from light. According to this embodiment, the ceramic package 41 is sealed with the glass plate 48 equipped with the light shielding film 49. In the example shown in Fig. 1A, the transparent portion 50 is formed in the light shielding film 49 only right above the solid state imaging device chip 45.

Although the container 41a, the frame body 41b and the lead 43 are used to constitute the ceramic package 41 in the above case, a printed circuit and a lead are connected by brazing outside the ceramic package 41 in some type of imaging apparatus. Moreover, a hollow plastic package made of opaque plastics may be used instead of the ceramic package 41.

The provision of a lens on the front side of the solid state imaging device chip 45 is effective in making the most of incident light. In order to attain such a structure according to this embodiment of the invention, a lens-like transparent material 51 may be formed on one side of an area on the glass plate 48, which area corresponds to the transparent portion 50, as shown in Fig. 1A or Fig. 1C. In the case of Fig. 1C, the formation of the lens-like transparent material 51 on the inside of the ceramic package 41 results in making flat the surface of the glass plate 48, thus preventing the lens-like transparent material 51 from obstructing the work of incorporating the imaging apparatus into a camera and the like. When a pin-hole lens is incorporated in the imaging apparatus shown in Fig. 1C, the externally-mounted lens can be omitted and the simplification of the structure makes it possible to provide a small-sized slim camera system.

As set forth above, the imaging apparatus itself can be made small-sized by accommodating the solid state imaging device chip 45 and the peripheral circuit element chip 46 within the same package, and the resulting decreased wiring length contributes to improving the electric characteristics.

### Second Embodiment

Fig. 2 is a sectional view of an imaging apparatus according to second embodiment of the present invention, wherein like reference characters are given to like component parts and the description thereof will be omitted since the imaging apparatus is basically similar in construction to what is shown in first embodiment of Fig. 1. According to second embodiment of the present invention substantially like the first Embodiment thereof, the substrate 44 mounted with the solid state imaging device chip 45 and the peripheral circuit element chip 46 is accommodated within the ceramic package 41 equipped with the depression 42.

What makes this embodiment of the invention different from the first embodiment thereof is that the peripheral circuit element chip 46 is mounted on the substrate 44 facedown and salient electrodes 47a made of solder or gold are formed at the terminal of the peripheral circuit element chip 46.

According to this embodiment of the invention, one side, where a circuit is formed, of the peripheral circuit element chip 46 is directed to the substrate 44 and the height of the salient electrode 47a after the peripheral circuit element chip 46 has been mounted is several µm, so that external light is never allowed to reach the circuit side of the peripheral circuit element chip 46. Therefore, no light shielding film is required to be formed on the glass plate 48 for sealing up the ceramic package 41.

### Third Embodiment

Fig. 3 is a sectional view of an imaging apparatus according to third embodiment of the present invention, wherein like reference characters are given to like component parts and the description thereof will be omitted. In Fig. 3, reference numeral 51 denotes a silicon substrate; and 52, a solid state imaging device formed on part of the silicon substrate. The salient electrodes 47a are also formed at the electrode terminal of the peripheral circuit element chip 46 in this case and the salient electrodes 47a are used to mount the peripheral circuit element chip 46 on the silicon substrate 51.

The formation of mutual wiring including simultaneously mounting the solid state imaging device 52 and the peripheral circuit element chip 46 on part of the silicon substrate 51 through the process of manufacturing the solid state imaging device chip makes it possible to make the imaging apparatus further smaller than those in the first and second embodiments of the present invention and to accomplish actually an imaging apparatus resistant to noise because the length of the mutual wiring is reduced.

Although a description has been given of an example in which the peripheral circuit element chip 46 is mounted facedown according to this embodiment of the invention, such a peripheral circuit element chip 46 may mounted faceup, and the terminal of the peripheral circuit element chip 46 and the conductor wiring on the silicon substrate 51 may connected by the use of a thin metal wire. In this case, however, it is preferred to formed the glass plate 48 with a light shielding film or otherwise the surface of the peripheral circuit element chip 46 is covered with opaque plastics lest external light is incident on the circuit side of the peripheral circuit element chip 46.

### Fourth Embodiment

Fig. 4 is a sectional view of an imaging apparatus according to fourth embodiment of the present invention, wherein like reference characters are given to like component parts and the description thereof will be omitted since the imaging apparatus is basically similar in construction to what is shown in the first embodiment of Fig. 1. In Fig. 4, reference number 53 denotes an opaque plastic layer for shielding the surface, that is, the surface where a circuit is formed, of the peripheral circuit element chip 46.

What makes this embodiment of the invention different from Embodiment 1 thereof is that the circuit side of the peripheral circuit element chip 46 is covered with the opaque plastic layer 53 according to this embodiment of the invention, whereas the glass plate 48 is formed with the light shielding film 49 so as to prevented external light from being incident on the circuit side of the peripheral circuit element chip 46 according the first embodiment thereof.

The peripheral circuit element chip 46 is thus mounted faceup and the circuit side thereof is covered with the opaque plastic layer 53, whereby in addition to the functional effect of first embodiment of the present invention, the production cost is made reducible by the cost of the glass plate 48.

### Fifth Embodiment

Figs. 5A and 5B are sectional views of an imaging apparatus according to fifth embodiment 5 of the present invention, wherein like reference characters are given to like component parts and the description thereof will be omitted since the imaging apparatus is basically similar in construction to what is shown in the first embodiment of Fig. 1. In Figs. 5A and 5B, reference numeral 54 denotes an opaque plate; and 55, a glass window bonded to an opening provided in part of the opaque plate 54.

What makes this embodiment of the invention different from the first embodiment thereof is that the opaque plate 54 made of metal or opaque plastic plate instead of the glass plate 48 is used according to this embodiment of the invention, whereas the glass plate 48 is formed with the light shielding film 49 and the transparent portion 50 is formed in part of the light shielding film 49 according to first embodiment thereof. The glass window 55 for introducing external light to the solid state imaging device chip 45 accommodated in the ceramic package 41 is bonded to the opaque plate 54. An opening which is L-shaped in cross section is provided in the opaque plate 54 so as to bond the glass window 55 thereto and the glass window 55 is fitted into the opening from above in the example shown in Fig. 5A, whereas the glass window 55 is fitted into the opening from below in the example shown in Fig. 5B. In either case, metal having higher strength than a glass plate or opaque plastic plate which is hard to crack is usable, so that the strength of an imaging apparatus is far improvable in comparison with the glass plate.

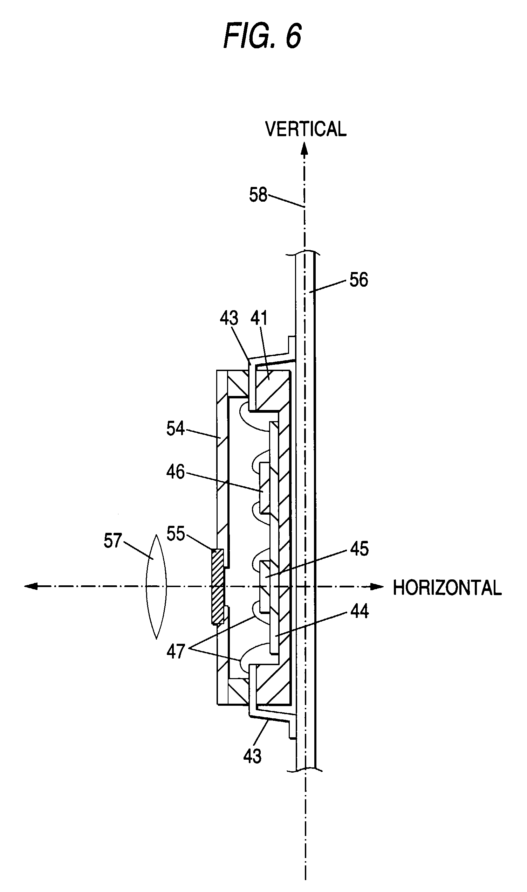

Fig. 6 is a sectional view explanatory of a case where an imaging apparatus according to sixth embodiment of the present invention is mounted on a circuit board. In Fig. 6, like reference characters are given to like component parts of Figs. 5A and 5B and the description thereof will be omitted, wherein reference numeral 56 denotes a circuit board; 57, a lens; and 58, a perpendicular direction.

When a video camera is used in general, the main surface of an imaging apparatus becomes parallel to the perpendicular direction under the most photographic conditions as shown in Fig. 6. Therefore, the board with the packaging of the solid state imaging device chip 45 and the peripheral circuit element chip 46 within the imaging apparatus is also set parallel to the perpendicular direction. According to this embodiment of the invention, the solid state imaging device chip 45 is placed on the lower side, whereas the peripheral circuit element chip 46 whose heat value is greater than that of the solid state imaging device chip 45 is placed on the upper side. Although only one peripheral circuit element chip 46 is shown in Fig. 6, a plurality of peripheral circuit element chips have actually been packaged.

Inactive gas such as nitrogen gas and argon gas, dried air and the like are enclosed in the package 41. Consequently, the gas warmed as the solid state imaging device chip 45 generates heat carries heat upward and the temperature of the upper portion of the package 41 tends to become higher than that of the lower portion thereof due to a convention current.

Therefore, the peripheral circuit element chip 46 is placed upward in the perpendicular direction of the solid state imaging device chip 45 as in this embodiment of the invention, whereby a rise in the temperature of the solid state imaging device chip 45 is suppressible.

The perpendicular transfer stage of the solid state imaging device chip 45 and the horizontal transfer stage at which a signal is transfer from the perpendicular stage to the horizontal stage have directivity in the imaging area and when the solid state imaging device chip 45 is mounted in the camera, for example, and used, upper, lower, left and right directions have unitarily been determined. Therefore, it should be needed to determine the arrangement of the solid state imaging device chip 45 and the peripheral circuit element chip 46 at the stage of the imaging apparatus as in this embodiment of the invention.

### Seventh Embodiment

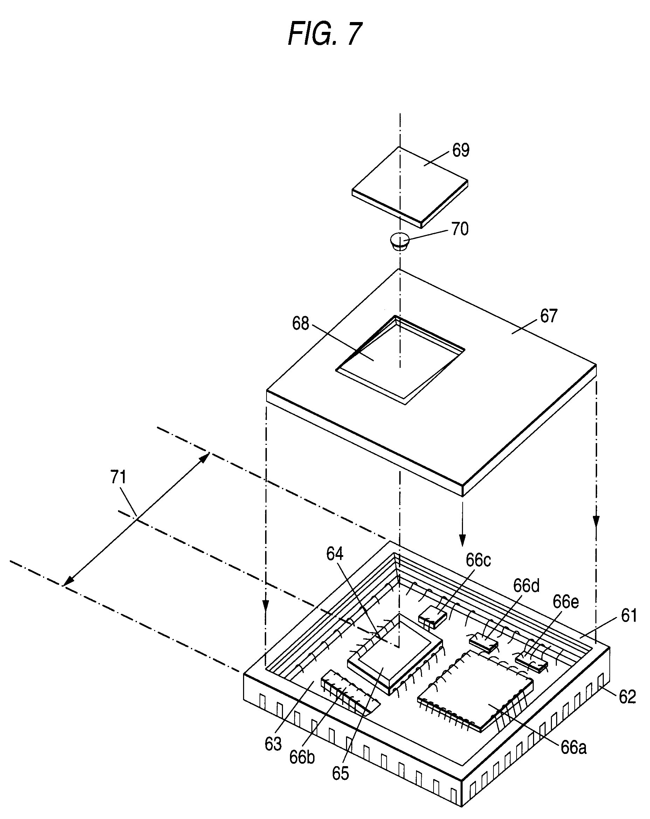

Fig. 7 is a development of an imaging apparatus according to seventh embodiment of the present invention. In Fig. 7, reference numeral 61 denotes a ceramic package; 62, terminals formed from the side face to the bottom face of the ceramic package 61; 63, a substrate; 64, a solid state imaging device chip; 65, an imaging area of the solid state imaging device chip 64; 66a - 66e, peripheral circuit element chips, together with the solid state imaging device chip 64, constituting the imaging apparatus; 67, an opaque plate; 68, an opening provided in the opaque plate; 69, a glass window for sealing up the opening 68; 70, a lens-like transparent material formed on or fitted to the glass window 69; and 71, a bisector of the one side of the ceramic package 61. Further, 66a - 66e denote ICs including an IC forming a driving unit, an IC forming a signal processing unit, and an IC forming a control unit. These ICs are not formable on the same chip at present because they are manufactured under different processing conditions.

The solid state imaging device chip 64, the peripheral circuit element chips 66a-66e and circuit component parts such as resistors, capacitors, coils and the like are packaged on the substrate 63. The substrate 63 is accommodated in the ceramic package 61 and then thin metal wires are used to connect conductor wiring on the substrate 63 and the external terminals of the ceramic package 61 on the substrate 63.

Fig. 7 is a development and though the opaque plate 67, the glass window 69 and the lens-like transparent material 70 are shown separately, they are actually those which have been integrated into one unit beforehand. Although the lens-like transparent material 70 is to be mounted on the undersurface of the glass window 69 in this example, the lens-like transparent body 70 may be attached to the surface of the glass window 69.

As shown in Fig. 7, the center of the imaging area 65 of the solid state imaging device chip 64 in this example is designed/arranged so that it is situated on the bisector of one side of the ceramic package 61. Thus, the alignment of optical axes is facilitated when the imaging apparatus according to this embodiment of the invention is incorporated into the camera. By conforming the intersection point of diagonal lines of the ceramic package 61 to the center of the imaging area 65, further, only the external shape of the ceramic package 61 substantially allows positioning to be regulated when the imaging apparatus is incorporated into the camera.

### Eighth Embodiment

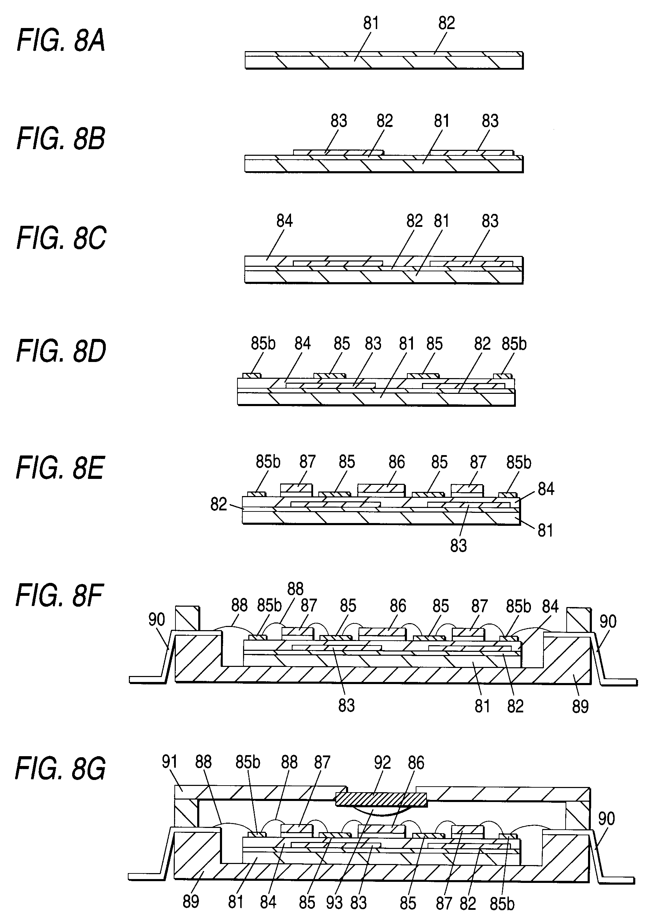

Figs. 8A to 8G are sectional views showing a process of manufacturing an imaging apparatus, the sectional views being explanatory of steps in the process thereof according to eighth embodiment of the present invention. As shown in Fig. 8A first, a silicon oxide film 82 is formed on the surface of a silicon substrate 81 by thermal oxidation. Subsequently, an aluminum alloy film is formed on the silicon oxide film 82 by sputtering before being selectively etched so as to form first conductor wiring 83 as shown in Fig. 8B. Subsequently, as shown in Fig. 8C, a silicon nitride film 84 is formed on the whole surface using the plasma CVD method. Subsequently, an opening (not shown) communicating with the first conductor wiring 83 is formed in part of the silicon nitride film 84 and then an aluminum alloy film is formed on the whole surface. The aluminum alloy film is selectively etched so as to form second conductor wiring 85 as shown Fig. 8D. Reference numeral 85b denotes an external connection terminal on the substrate and the thickness of the external connection terminal can be increased by removing the silicon nitride film 84 from the portion corresponding to the terminal and stacking up the first conductor wiring and the second conductor wiring. In this case, wire bonding can readily be carried out when the substrate and the ceramic package are finally and mutually connected with the result that the reliability of connecting them is improved.

As shown in Fig. 8E, further, electroconductive paste is used for firmly bonding a solid state imaging device chip 86 and peripheral circuit element chips 87 to predetermined corresponding positions, respectively.

Subsequently, thin metal wires are used for connecting the second conductor wiring 85 and the electrodes of the solid state imaging device chip 86 and the peripheral circuit element chips 87 on the silicon substrate 81. Further, the substrate 81 is mounted on the ceramic package 89 after inspection is made as shown in Fig. 8F. Subsequently, metal wiring 88 is used for connecting the external connection terminals 85b on the substrate 81 and a lead 90 of the ceramic package 89.

Subsequently, as shown in Fig. 8G, a cover body is used for hermetically sealing up the ceramic package 89, which cover body is the one completed by attaching a glass window 92 having a lens 93 to an opening bored in part of an opaque plate 91.

A description has been given of a case where the package is a ceramic package and the substrate is a ceramic substrate in the first to eighth embodiments. However, a similar effect is obtainable from a plastic package which is equipped with a depression. Although a description has been given of an example in which the ceramic substrate is used as a substrate, a glass substrate, a plastic substrate and the like other than the ceramic substrate may be used. In view of improving thermal radiation and preventing unnecessary radiation, what is provided with thin-film conductor wiring formed on an insulating film which is formed on the surface of an electroconductive substrate. Moreover, high-density wiring is made attainable by using a silicon substrate as a substrate and utilizing ordinary semiconductor manufacturing technology for the formation of an insulating film and conductor wiring. When an insulating substrate such as a ceramic substrate, a glass substrate, a plastic substrate and the like is used, unnecessary radiation can be prevented by forming the insulating film after forming the electroconductive film on the surface. Although there has been shown an example of Galwind type where the lead of a package is bent outside, entirely the same effect is obtainable likewise by the use of a J-bend type where the lead is bent to the package side, a ceramic package having the external terminals formed by printed wiring from the side face up to the bottom face of the package as shown in Fig. 7 and further a hollow plastic package.

As set forth above, according to the present invention, the substrate mounted with the solid state imaging device chip and the peripheral circuit element chips is accommodated in the ceramic or plastic hollow package. Therefore, the imaging apparatus can be made compact and the wiring length between the solid state imaging device chip and the peripheral circuit element chip is reducible, so that an imaging apparatus excellent in electrical characteristics is attainable.

Particularly, the silicon substrate prepared by forming the insulating film on the electroconductive substrate allows high-density wiring to be materialize since fine wiring and multilayer wiring are readily formable and consequently a small-sized lightweight imaging apparatus that has not been made yet before can be materialized. The reduced leading of wiring makes the wiring capacity become reducible, and the charge/discharge current corresponding to the wiring capacity is also reducible, whereupon unnecessary radiation is suppressed. Moreover, the reduced leading of wiring prevents a signal delay and this results in suppressing the deterioration of image quality as the signal can be transmitted at high speed.

When a video camera is used with the surface of the substrate of the imaging apparatus being set parallel to the perpendicular direction, the temperature of the solid state imaging device chip is prevented from rising by disposing the chip, out of the peripheral circuit element chips, whose heat value is greater than the solid state imaging device chip above the solid state imaging device chip. In this case, dark current originating from the temperature rise can be made lower than what is based on the conventional arrangement.

In addition to the effect derived from the arrangement described above, the alignment of the optical axes is facilitated by conforming the center of the imaging area of the solid state imaging device chip to the bisector of one side of the external shape of the package or the intersection point of diagonal lines of the external shape thereof when the imaging apparatus is incorporated into a camera. Due to the fact that the alignment of axes is possible with the external shape of the package like this as a basis, the imaging apparatus can readily be incorporated into a camera which is increasingly made more compact.

With the progress of the semiconductor manufacturing technology in the future, even though solid state imaging device chips, driving circuits, signal processing circuits, control circuits, communication input-output circuits and their input-output terminals and the like are converted into IC chips, extremely small-sized slim camera systems are made materializable by putting into practical use the imaging apparatus which incorporates circuit portions other than those enumerated above according to the present invention.

## Claims

1. An imaging apparatus comprising:
a substrate on which a solid state imaging device chip and peripheral circuit element chips are mounted;
a container having a recessed portion in which said substrate is placed;
a transparent cover body which seals said container to make a space inside said container.

2. An imaging apparatus as claimed in claim 1, further comprising a light shielding film, which has a transparent portion corresponding to the imaging area of the solid state imaging device chip, on at least one of the surface and the undersurface of the transparent cover body.

3. An imaging apparatus as claimed in claim 2, further comprising a lens member disposed in an area on the surface or undersurface of the cover body corresponding to said transparent portion.

4. An imaging apparatus as claimed in claim 1, wherein said substrate is an electroconductive substrate with an insulating film formed on the surface and further thin-film conductor wiring formed on the insulating film.

5. An imaging apparatus as claimed in claim 4, wherein the electroconductive substrate is a silicon substrate or a metal substrate.

6. An imaging apparatus as claimed in claim 1, wherein said substrate is formed by forming an electroconductive film on an insulating substrate and further forming an insulating film thereon and wherein thin-film conductor wiring is formed on the insulating film.

7. An imaging apparatus as claimed in claim 1, wherein said substrate is an insulating substrate and
thin-film conductor wiring is formed on the one-side principal surface of said substrate, whereas an electroconductive film is formed over substantially the entire the-other-side principal surface thereof.

8. An imaging apparatus as claimed in claim 1, wherein the solid state imaging device chip is mounted on the substrate faceup with the peripheral circuit element chips mounted on the substrate facedown.

9. A imaging apparatus comprising:
a semiconductor substrate;
a solid state imaging device chip and thin-film conductor wiring formed in one principal surface of the semiconductor substrate;
peripheral circuit element chips mounted in a predetermined area on said semiconductor substrate;
a container having a recessed portion in which said substrate is placed;
a cover body which seals said container to make a space inside said container, said cover body whose area corresponding to the imaging area of at least the solid state imaging device chip is transparent.

10. An imaging apparatus as claimed in claim 9, wherein said peripheral circuit element chips are mounted facedown.

11. An imaging apparatus as claimed in claim 9, wherein the peripheral circuit element chips are mounted faceup and wherein at least the surface of the peripheral circuit element chip is covered with opaque plastics.

12. An imaging apparatus comprising:
a substrate on which a solid state imaging device chip and peripheral circuit element chips are mounted;
a container having a recessed portion in which said substrate is placed;
an opaque cover body which has a transparent window at upper portion thereof and seals said container to make a space inside said container.

13. An imaging apparatus as claimed in claim 12, further comprising a lens member at a surface or an undersurface among the principal surfaces of the transparent window.

14. An imaging apparatus as claimed in claims 1, 2, 4, 9 or 12, wherein the solid state imaging device chip and the peripheral circuit element chips are disposed on the substrate so that when the principal surface of an imaging device is held in parallel to a perpendicular line so as to take a photograph, at least the peripheral circuit element chips which generates heat greater than the solid state imaging device chip are placed above the solid state imaging device chip.

15. An imaging apparatus as claimed in either claim 1 or claim 9, wherein the solid state imaging device chip is placed so that the center of the imaging area of the solid state imaging device chip conforms to the bisector of one side of the external shape of the container.

16. An imaging apparatus as claimed in either claim 1 or claim 9, wherein the solid state imaging device chip is placed so that the center of the imaging area of the solid state imaging device chip conforms to the intersection of diagonals of the external shape of the container.

17. A process for producing an imaging apparatus, comprising the steps of:
forming a first insulating film on an electroconductive substrate;
forming a first thin-film conductor wiring on the first insulating film;
forming a second insulating film covering the first thin-film conductor wiring;
forming a second thin-film conductor wiring on the second insulating film;
mounting a solid state imaging device chip and peripheral circuit element chips on the substrate;
connecting the electrode of each chip to either first or second thin-film conductor wiring;
installing the substrate within a container;
connecting either first or second thin-film conductor wiring on the substrate to the external lead of the container; and
hermetically sealing up the container with a cover body having a transparent portion in a portion corresponding to the imaging area of at least the solid state imaging device chip.

18. A process for producing an imaging apparatus as claimed in claim 17, wherein the electroconductive substrate is a silicon substrate and wherein the insulating film is a silicon oxide film, a silicon nitride film or a silicon nitride oxide film.
